# EUROPEAN PATENT APPLICATION

(11) **EP 4 357 134 A1**
(43) Date of publication of application: **24.04.2024**
(21) Application number: 22382998.7
(22) Date of filing: 18.10.2022
(51) Int. Cl.: B32B 27/32, B32B 7/02, B32B 7/12, B32B 27/08, B32B 27/16, B32B 27/30, C08J 5/18, C08L 23/08

(54) **ORIENTED MULTILAYER FILM INCLUDING METAL LAYER**

(71) Applicant: Dow Global Technologies LLC, Midland, MI 48674 (US)
(72) Inventor: HILL, Martin Keith, 43006 Tarragona (ES); SAHU, Nrusingh, 43006 Tarragona (ES)
(74) Representative: Elzaburu S.L.P.

(57) **Abstract**

The present disclosure provides a film structure. In an embodiment, the film structure comprises a machine direction oriented (MDO) multilayer film. The MDO multilayer film comprises (a) a first outer layer (FOL) comprising (i) a FOL first ethylene/α-olefin copolymer having a density from 0.900 g/cc to 0.920 g/cc, and (ii) an optional ethylene-based polymer selected from the group consisting of (1) a FOL second ethylene/α-olefin copolymer having a density from 0.920 g/cc to 0.980 g/cc; and (2) a FOL third ethylene-based polymer (LDPE). The MDO multilayer film comprises (b) a first intermediate layer (FIL) in direct contact with the first outer layer. The first intermediate layer (FIL) comprises an FIL first ethylene/α-olefin copolymer having a density from 0.920 g/cc to 0.980 g/cc. The MDO film multilayer comprises (c) a core layer (CL) in direct contact with the first intermediate layer. The core layer (c) comprises a CL first ethylene-based polymer having a density from 0.920 g/cc to 0.980 g/cc; and a metal layer on the first outer layer (a).

## Description

### FIELD

The present disclosure relates to oriented multilayer film, and more specifically, oriented multilayer film including a metal layer.

### BACKGROUND

Multilayer film structures that include a metal layer (*i.e.,* a metallized film formed by depositing a layer of metal and/or metal oxide onto a layer of the film) are widely used for packaging perishable food and products. The thin coating provided by the metal layer improves barrier properties, and decreases liquid, gas, and/or vapor permeation through the multilayer film.

In an effort to improve recyclability and expand sustainability, the flexible packaging market is moving toward mono-material solutions based on ethylene-based polymers. Oriented film, and machine direction oriented (MDO) film in particular, made from ethylene-based polymer is evolving as a viable substrate to be used in mono-material flexible packaging as polyethylene-based oriented film provides optics, tensile strength, and stiffness suitable for many flexible packaging applications. However, the non-polar nature of ethylene-based polymers makes it difficult to apply a metal layer onto a multilayer film structure with a metal receptive layer composed of ethylene-based polymer.

The art therefore recognizes the need for oriented multilayer film composed of ethylene-based polymer that provides (i) improved metal layer adhesion (improved bonding strength), balanced with (ii) low gas and/or low liquid permeation through the multilayer film.

### SUMMARY

The present disclosure provides a film structure. In an embodiment, the film structure comprises a machine direction oriented (MDO) multilayer film. The MDO multilayer film comprises (a) a first outer layer (FOL) comprising (i) a FOL first ethylene/α-olefin copolymer having a density from 0.900 g/cc to 0.920 g/cc, and (ii) an optional ethylene-based polymer selected from the group consisting of (1) a FOL second ethylene/α-olefin copolymer having a density from 0.920 g/cc to 0.980 g/cc; and (2) a FOL third ethylene-based polymer (LDPE). The MDO multilayer film comprises (b) a first intermediate layer (FIL) in direct contact with the first outer layer. The first intermediate layer (FIL) comprises an FIL first ethylene/α-olefin copolymer having a density from 0.920 g/cc to 0.980 g/cc. The MDO multilayer film comprises (c) a core layer (CL) in direct contact with the first intermediate layer. The core layer (c) comprises a CL first ethylene-based polymer having a density from 0.920 g/cc to 0.980 g/cc; and a metal layer on the first outer layer (a).

### DEFINITIONS

Any reference to the Periodic Table of Elements is that as published by CRC Press, Inc., 1990-1991. Reference to a group of elements in this table is by the new notation for numbering groups.

For purposes of United States patent practice, the contents of any referenced patent, patent application or publication are incorporated by reference in their entirety (or its equivalent U.S. version is so incorporated by reference) especially with respect to the disclosure of definitions (to the extent not inconsistent with any definitions specifically provided in this disclosure).

The numerical ranges disclosed herein include all values from, and including, the lower and upper value. For ranges containing explicit values (*e.g*., from 1 or 2, or 3 to 5, or 6, or 7), any subrange between any two explicit values is included (*e.g.*, the range 1-7 above includes subranges of from 1 to 2; from 2 to 6; from 5 to 7; from 3 to 7; from 5 to 6; etc.).

Unless stated to the contrary, implicit from the context, or customary in the art, all parts and percents are based on weight and all test methods are current as of the filing date of this disclosure.

The terms "blend" or "polymer blend," as used, refers to a mixture of two or more polymers. A blend may or may not be miscible (not phase separated at molecular level). A blend may or may not be phase separated. A blend may or may not contain one or more domain configurations, as determined from transmission electron spectroscopy, light scattering, x-ray scattering, and other methods known in the art. The blend may be effected by physically mixing the two or more polymers on the macro level (for example, melt blending resins or compounding), or the micro level (for example, simultaneous forming within the same reactor).

The term "composition" refers to a mixture of materials which comprise the composition, as well as reaction products and decomposition products formed from the materials of the composition.

The terms "comprising," "including," "having" and their derivatives, are not intended to exclude the presence of any additional component, step or procedure, whether or not the same is specifically disclosed. In order to avoid any doubt, all compositions claimed through use of the term "comprising" may include any additional additive, adjuvant, or compound, whether polymeric or otherwise, unless stated to the contrary. In contrast, the term "consisting essentially of" excludes from the scope of any succeeding recitation any other component, step, or procedure, excepting those that are not essential to operability. The term "consisting of" excludes any component, step, or procedure not specifically delineated or listed. The term "or," unless stated otherwise, refers to the listed members individually as well as in any combination.

The term "direct contact," or "directly contacts," or "is in direct contact with," or similar terms refers to a layer configuration whereby a first layer is located immediately adjacent to a second layer and no intervening layers or no intervening structures are present between the first layer and the second layer.

"Polyethylene" or "ethylene-based polymer" is a polymer comprising a majority amount (>50 mol %) of units which have been derived from ethylene monomer. This includes polyethylene homopolymers or copolymers (meaning units derived from two or more comonomers). Common forms of polyethylene known in the art include Low Density Polyethylene (LDPE); Linear Low Density Polyethylene (LLDPE); Ultra Low Density Polyethylene (ULDPE); single-site catalyzed Linear Low Density Polyethylene, including both linear and substantially linear low density resins (m-LLDPE); ethylene-based plastomers (POP) and ethylene-based elastomers (POE); Medium Density Polyethylene (MDPE); and High Density Polyethylene (HDPE). These polyethylene materials are generally known in the art; however, the following descriptions may be helpful in understanding the differences between some of these different polyethylene resins.

The term "LDPE" may also be referred to as "high pressure ethylene polymer" or "highly branched polyethylene" and is defined to mean that the polymer is partly or entirely homo-polymerized or copolymerized in autoclave or tubular reactors at pressures above 14,500 psi (100 MPa) with the use of free-radical initiators, such as peroxides (see for example US 4,599,392, which is hereby incorporated by reference). LDPE resins typically have a density in the range of 0.916 to 0.935 g/cm³.

The term "LLDPE", includes both resin made using the traditional Ziegler-Natta catalyst systems and chromium-based catalyst systems as well as single-site catalysts, including, but not limited to, substituted mono- or bis-cyclopentadienyl catalysts (typically referred to as metallocene), constrained geometry catalysts, pyridylamine catalysts, phosphinimine catalysts & polyvalent aryloxyether catalysts (typically referred to as bisphenyl phenoxy), and includes linear, substantially linear or heterogeneous polyethylene copolymers or homopolymers. LLDPEs contain less long chain branching than LDPEs and includes the substantially linear ethylene polymers which are further defined in U.S. Patent 5,272,236, U.S. Patent 5,278,272, U.S. Patent 5,582,923 and US Patent 5,733,155; the homogeneously branched linear ethylene polymer compositions such as those in U.S. Patent No. 3,645,992; the heterogeneously branched ethylene polymers such as those prepared according to the process disclosed in U.S. Patent No. 4,076,698; and/or blends thereof (such as those disclosed in US 3,914,342 or US 5,854,045). The LLDPEs can be made via gas-phase, solution-phase or slurry polymerization or any combination thereof, using any type of reactor or reactor configuration known in the art.

The term "MDPE" refers to polyethylenes having densities from 0.926 to 0.935 g/cm³. "MDPE" is typically made using chromium or Ziegler-Natta catalysts or using single-site catalysts including, but not limited to, substituted mono- or bis-cyclopentadienyl catalysts (typically referred to as metallocene), constrained geometry catalysts, pyridylamine catalysts, phosphinimine catalysts & polyvalent aryloxyether catalysts (typically referred to as bisphenyl phenoxy), and typically have a molecular weight distribution ("MWD") greater than 2.5.

The term "HDPE" refers to polyethylenes having densities greater than about 0.935 g/cm³ and up to about 0.980 g/cm³, which are generally prepared with Ziegler-Natta catalysts, chrome catalysts or single-site catalysts including, but not limited to, substituted mono- or bis-cyclopentadienyl catalysts (typically referred to as metallocene), constrained geometry catalysts, pyridylamine catalysts, phosphinimine catalysts & polyvalent aryloxyether catalysts (typically referred to as bisphenyl phenoxy).

The term "ULDPE" refers to polyethylenes having densities of 0.855 to 0.912 g/cm³, which are generally prepared with Ziegler-Natta catalysts, chrome catalysts, or single-site catalysts including, but not limited to, substituted mono- or bis-cyclopentadienyl catalysts (typically referred to as metallocene), constrained geometry catalysts, pyridylamine catalysts, phosphinimine catalysts & polyvalent aryloxyether catalysts (typically referred to as bisphenyl phenoxy). ULDPEs include, but are not limited to, polyethylene (ethylene-based) plastomers and polyethylene (ethylene-based) elastomers. Polyethylene (ethylene-based) elastomers plastomers generally have densities of 0.855 to 0.912 g/cm³.

The term "ethylene monomer," or "ethylene," as used herein, refers to a chemical unit having two carbon atoms with a double bond there between, and each carbon bonded to two hydrogen atoms, wherein the chemical unit polymerizes with other such chemical units to form an ethylene-based polymer composition.

A "heteroatom" is an atom other than carbon or hydrogen. The heteroatom can be a non-carbon atom from Groups IV, V, VI and VII of the Periodic Table. Nonlimiting examples of heteroatoms include: F, N, O, P, B, S, and Si.

A "hydrocarbon" is a compound containing only hydrogen atoms and carbon atoms. A "hydrocarbonyl" (or "hydrocarbonyl group") is a hydrocarbon having a valence (typically univalent). A hydrocarbon can have a linear structure, a cyclic structure, or a branched structure.

A "laminate," as used herein, includes a first film structure, a second film structure, and an adhesive layer between the first film structure and the second film structure. The first film structure and/or the second film structure can be a monolayer film or a multilayer film.

A "machine direction oriented film" or "MDO film" is a film stretched (or oriented) in the machine direction at a draw ratio from 4:1 to 12:1. The MDO film is a uniaxially oriented film. The stretching or orienting of the film is performed by way of machine direction orientation rolls, via tentering, or via intermeshing gears whereby the film is ringrolled, or otherwise incrementally stretched in the machine direction and below the melting point of the film.

A "multilayer structure" is a structure having more than one layer. For example, the multilayer structure may have two, three, four, five or more layers. A multilayer structure may be described as having the layers designated with letters. For example, a three layer structure having a core layer B, and two external layers A and C may be designated as A/B/C.

An "olefin" is an unsaturated, aliphatic hydrocarbon having a carbon-carbon double bond.

An "olefin-based polymer" (interchangeably referred to as "polyolefin") is a polymer that contains a majority weight percent of polymerized olefin monomer (based on the total amount of polymerizable monomers), and optionally, may contain at least one comonomer. Nonlimiting examples of olefin-based polymer include ethylene-based polymer and propylene-based polymer.

The term "polymer" or a "polymeric material," as used herein, refers to a compound prepared by polymerizing monomers, whether of the same or a different type, that in polymerized form provide the multiple and/or repeating "units" or "mer units" that make up a polymer. The generic term polymer thus embraces the term homopolymer, usually employed to refer to polymers prepared from only one type of monomer, and the term copolymer, usually employed to refer to polymers prepared from at least two types of monomers. It also embraces all forms of copolymer, e.g., random, block, etc. The terms "ethylene/α-olefin polymer" and "propylene/α-olefin polymer" are indicative of copolymer as described above prepared from polymerizing ethylene or propylene respectively and one or more additional, polymerizable α-olefin monomer. It is noted that although a polymer is often referred to as being "made of" one or more specified monomers, "based on" a specified monomer or monomer type, "containing" a specified monomer content, or the like, in this context the term "monomer" is understood to be referring to the polymerized remnant of the specified monomer and not to the unpolymerized species. In general, polymers herein are referred to as being based on "units" that are the polymerized form of a corresponding monomer.

A "propylene-based polymer" (interchangeably referred to as "polypropylene") is a polymer that contains more than 50 mole percent polymerized propylene monomer (based on the total amount of polymerizable monomers) and, optionally, may contain at least one comonomer. Propylene-based polymer includes propylene homopolymer, and propylene copolymer (meaning units derived from propylene and one or more comonomers). The terms "propylene-based polymer" and "polypropylene" may be used interchangeably. A nonlimiting example of a propylene-based polymer (polypropylene) is a propylene/α-olefin copolymer with at least one C₂ or C₄-C₁₀ α-olefin comonomer.

### DETAILED DESCRIPTION

The present disclosure provides a film structure. In an embodiment, the film structure includes a machine direction oriented (MDO) multilayer film and a metal layer. The MDO multilayer film includes (a) a first outer layer ("FOL"). The first outer layer (a) includes (i) a FOL first ethylene/α-olefin copolymer having a density from 0.900 g/cc to 0.920 g/cc, and (ii) an optional ethylene-based polymer selected from (1) a FOL second ethylene/α-olefin copolymer having a density from 0.920 g/cc to 0.980 g/cc, (2) a FOL third ethylene-based polymer, and (3) combinations thereof. The MDO multilayer film includes (b) a first intermediate layer ("FIL") in direct contact with the first outer layer. The first intermediate layer (b) includes a FIL first ethylene/α-olefin copolymer having a density from 0.920 g/cc to 0.980 g/cc. The MDO multilayer film includes (c) a core layer ("CL") in direct contact with the first intermediate layer (b). The core layer (c) includes a CL first ethylene/α-olefin copolymer having a density from 0.920 g/cc to 0.980 g/cc. The metal layer is on the first outer layer (a).

Although the 1MDO film is oriented in the machine direction, it is understood the 1MDO film could be further oriented in the transverse (or cross) direction and be a bi-axially oriented film.

Each of the following terms and respective abbreviation are used interchangeably: first outer layer (or FOL), first intermediate layer (or FIL), core layer (or CL), second intermediate layer (or SIL), second outer layer (or SOL), first sublayer (FSL), second sublayer (SSL), and skin layer (SL). In an embodiment, each ethylene-based polymer (and/or each ethylene/α-olefin copolymer) is a hydrocarbon. The ethylene-based polymers disclosed herein are identified by location, namely, identified by the film layer in which the ethylene-based polymer resides. It is understood that an ethylene-based polymer present in a first layer (*i.e*., present in the skin layer or SL) may or may not be the same ethylene-based polymer that is present in a second layer (*i.e*., present in the core layer or CL). The term "different than" as it relates to ethylene-based polymers (or ethylene/α-olefin copolymers) indicates that an ethylene-based polymer has at least one property or property value dissimilar to the corresponding property in another ethylene-based polymer. Nonlimiting examples of ethylene-based polymer (or ethylene/α-olefin copolymer) properties include comonomer type, comonomer amount, density, melt index, and/or melt temperature. By way of example, a first ethylene/α-olefin copolymer that is "different than" a second ethylene/α-olefin copolymer may have a density value that is dissimilar to the density value of the second ethylene/α-olefin copolymer.

In an embodiment, the comonomer for ethylene/α-olefin copolymer is a C₃-C₁₂ α-olefin, or a C₄-C₁₀ α-olefin, or a C₄-C₈ α-olefin. In a further embodiment, the comonomer is butene, hexene, or octene

### 1. MDO Multilayer Film

The film structure includes the MDO multilayer film with the first outer layer (a). The first outer layer (a) is an outermost layer for the MDO multilayer film before the metal layer is applied thereto. The first outer layer (a) interfaces directly with the metal layer. The first outer layer (a) includes (i) an FOL first ethylene/α-olefin copolymer, (ii) an optional ethylene-based polymer selected from (1) an FOL second ethylene/α-olefin copolymer, (2) an FOL third ethylene-based polymer, (3) a combination of (1) and (2), and (iii) optional additives. The FOL first ethylene/α-olefin copolymer has a density from 0.900 g/cc to 0.920 g/cc. In an embodiment, the FOL first ethylene/α-olefin copolymer has a melt index from 0.2 g/10 min to 3.0 g/10 min, or from 0.2 g/10 min to 3 g/10 min, and a melt temperature from 95°C to 125°C, or from 95°C to 125°C.

In an embodiment, the first outer layer (a) includes (i) the FOL first ethylene/α-olefin copolymer having a density from 0.900 g/cc to 0.920 g/cc, a melt index from 0.5 g/10 min to 1.5 g/10 min, and a melt temperature from 95°C to 125°C, or from 95°C to 125°C, and the first outer layer (a) also includes (ii)(1) the FOL second ethylene/α-olefin copolymer, and (iii) optional additives. The FOL first ethylene/α-olefin copolymer is different than the FOL second ethylene/α-olefin copolymer. The FOL second ethylene/α-olefin copolymer has a density from 0.920 g/cc to 0.980 g/cc, or from 0.935 g/cc to 0.980 g/cc. In an embodiment, the FOL second ethylene/α-olefin copolymer has a melt index from 0.5 g/10 min to 1.5 g/10 min, and a melt temperature from 125°C to 135°C, or from 125°C to 135°C. In a further embodiment, the outer layer (a) includes from 50 wt% to 100 wt%, or from 50 wt% to 90 wt%, or from 60 wt% to 90 wt%, or 85 wt% of the FOL first ethylene/α-olefin copolymer having a density from 0.900 g/cc to 0.920 g/cc and a melt temperature from 95°C to 125°C, or from 105°C to 110°C and from 50 wt% to 0 wt%, or from 50 wt% to 10 wt%, or from 40 wt% to 10 wt%, or 15 wt% of the FOL second ethylene/α-olefin copolymer having a density from 0.935 g/cc to 0.980 g/cc and a melt temperature from 125°C to 135°C, or from 130°C to 135°C. Weight percent is based on total weight of the first outer layer (a).

In an embodiment, the first outer layer (a) includes (i) the FOL first ethylene/α-olefin copolymer having a density from 0.900 g/cc to 0.920 g/cc, a melt index from 0.5 g/10 min to 1.5 g/10 min, and a melt temperature from 95°C to 125°C, or from 105°C to 110°C, and the first outer layer (a) also includes (ii)(2) the FOL third ethylene-based polymer that is a LDPE having a density from 0.918 g/cc to 0.930 g/cc and a melt temperature from 105°C to 115°C. The FOL first ethylene/α-olefin copolymer is different than the FOL third ethylene-based polymer. In a further embodiment, the first outer layer (a) comprises (i) from 50 wt% to 100 wt%, or from 50 wt% to 90 wt%, or from 60 wt% to 90 wt%, or 85 wt% of the FOL first ethylene/α-olefin copolymer having a density from 0.900 g/cc to 0.920 g/cc, a melt index from 0.5 g/10 min to 1.5 g/10 min, and a melt temperature from 95°C to 125°C, or from 105°C to 110°C; and (ii)(2) from 50 wt% to 0 wt%, or from 50 wt% to 10 wt%, or from 40 wt% to 10 wt%, or 15 wt% of the FOL third ethylene-based polymer having a density from 0.910 g/cc to 0.930 g/cc, a melt index from 0.2 g/19 min to 3.0 g/10 min, or from 0.5 g/10 min to 1.5 g/10 min, and a melt temperature from 105°C to 115°C. Weight percent is based on total weight of the first outer layer (a).

The film structure includes the MDO multilayer film with the first intermediate layer (b). The first intermediate layer (b) is in direct contact with the first outer layer (a). The intermediate layer (b) includes (i) an FIL ethylene/α-olefin copolymer, (ii) an optional FIL second ethylene/α-olefin copolymer, and (iii) optional additives. The FIL first ethylene/α-olefin copolymer has a density from or from 0.920 g/cc to 0.980 g/cc, or from 0.935 g/cc to 0.980 g/cc.

In an embodiment, the first intermediate layer (b) includes (i) from 90 wt% to 100 wt%, or 100 wt% of the FIL first ethylene/α-olefin copolymer having a density from 0.935 g/cc to 0.980 g/cc, or from 0.940 g/cc to 0.980 g/cc, or from 0.940 g/cc to 0.950 g/cc and a melt temperature from 125°C to 135°C, or from 125°C to 129°C. Weight % is based on total weight of the intermediate layer (b).

In an embodiment, the first intermediate layer (b) includes the FIL first ethylene/α-olefin copolymer and the FIL second ethylene/α-olefin copolymer. The FIL first ethylene/α-olefin copolymer is different than the FIL second ethylene/α-olefin copolymer. In an embodiment, the first intermediate layer (b) includes (i) from 60 wt% to 90 wt%, or from 60 wt% to 80 wt%, or 70 wt% of the FIL first ethylene/α-olefin copolymer having a density from 0.935 g/cc to 0.980 g/cc, or from 0.940 g/cc to 0.980 g/cc, or from 0.940 g/cc to 0.950 g/cc a melt index from 0.5 g/10 min to 1.5 g/10 min, or from 0.5 g/10 min to less than 1.0 g/ 10 min, and a melt temperature from 125°C to 135°C, or from 125°C to 129°C. The first intermediate layer includes (ii) from 40 wt% to 10 wt%, or from 40 wt% to 20 wt%, or 30 wt% of the FIL second ethylene/α-olefin copolymer. In an embodiment, the FIL second ethylene/α-olefin copolymer has a density from 0.935 g/cc to 0.980 g/cc, or from 0.940 g/cc to 0.980 g/cc, or from 0.960 g/cc to 0.980 g/cc, a melt index from 0.5 g/10 min to 1.5 g/10 min, or from 1.0 g/10 min to 1.5g/10 min, and a melt temperature from 125°C to 135°C, or from 130°C to 135°C. Weight % is based on the total weight of the first intermediate layer (b).

The film structure includes the MDO multilayer film with the core layer (c). The core layer (c) is in direct contact with the first intermediate layer (b). The core layer (c) includes (i) a CL first ethylene/α-olefin copolymer, (ii) an optional CL second ethylene/α-olefin copolymer, and (iii) optional additives. In an embodiment, the core layer (c) includes from 90 wt% to 100 wt%, or 100 wt% of the CL first ethylene/α-olefin copolymer having a density from 0.920 g/cc to 0.980 g/cc, or from 0.935 g/cc to 0.980 g/cc, or from 0.940 g/cc to 0.950 g/cc, a melt index from 0.2 g/10 min to 2.0 g/10 min, to 0.5 g/10 min to 1.5 g/10 min, or from 0.5 g/10 min to less than 1.0 g/10 min, and a melt temperature from 125°C to 135°C, or from 125°C to 129°C. Weight % is based on total weight of the core layer (c).

In an embodiment, the film structure includes the MDO multilayer film with a first sublayer (d1). First sublayer (d1) is in direct contact with the core layer (c). The first sublayer (d1) includes one or more ethylene-based polymers.

In an embodiment, the first sublayer (d1) includes (i) a FSL first ethylene/α-olefin copolymer, (ii) an optional FSL second ethylene/α-olefin copolymer, and (iii) optional additives. The FSL first ethylene/α-olefin copolymer is different than the FSL second ethylene/α-olefin copolymer. The first sublayer (d1) includes (i) from 60 wt% to 100 wt%, or from 60 wt% to 90 wt%, or from 60 wt% to 80 wt%, or 70 wt% of the FSL first ethylene/α-olefin copolymer. In an embodiment, the FSL first ethylene/α-olefin copolymer has a density from 0.935 g/cc to 0.980 g/cc, or from 0.940 g/cc to 0.980 g/cc, or from 0.940 g/cc to 0.950 g/cc, a melt index from 0.5 g/10 min to 1.5 g/10 min, or from 0.5 g/10 min to less than 1.0 g/10 min, and a melt temperature from 125°C to 129°C. The first sublayer (d) includes (ii) from 40 wt% to 0 wt%, or from 40 wt% to 10 wt%, or from 40 wt% to 20 wt%, or 30 wt% of the FSL second ethylene/α-olefin copolymer. In an embodiment, the FSL second ethylene/α-olefin copolymer has a density from 0.935 g/cc to 0.980 g/cc, or from 0.940 g/cc to 0.980 g/cc, or from 0.960 g/cc to 0.980 g/cc, a melt index from 0.5 g/10 min to 1.5 g/10 min, or from greater than 1.0 g/10 min to 1.5 g/10 min and a melt temperature from 130°C to 135°C. Weight % is based on the total weight of the first sublayer (d1). In a further embodiment, the composition of the first sublayer (d1) is identical to the composition of the first intermediate layer (b).

In an embodiment, the first sublayer (d1) includes from 90 wt% to 100 wt%, or 100 wt% of a maleic anhydride-functionalized ethylene copolymer. The maleic anhydride-functionalized ethylene copolymer has a density from 0.870 g/cc to 0.940 g/cc, or from 0.870 g/cc to 0.89 g/cc, and a melt index, from 1.0 g/10 min to 3.0 g/10 min, or from 2.0 g/10 min to 3.0 g/10 min.

In an embodiment, the MDO multilayer film includes additional sublayers (d2), (d3), (d4), and (d5), and optionally additional sublayers. Each sublayer includes an ethylene-based polymer and optional additives. In a further embodiment, one of sublayers (d2), (d3), (d4), and (d5) includes ethylene vinyl alcohol (EVOH) and the remaining sublayers each includes an ethylene-based polymer.

In an embodiment, the film structure includes the MDO multilayer film with a skin layer (e). The skin layer (e) is in direct contact with one of the sublayers (d1), (d2), (d3), (d4), or (d5). The skin layer (e) includes (i) an SL first ethylene/α-olefin copolymer, (ii) an optional SL second ethylene/α-olefin copolymer, and (iii) optional additives.

In an embodiment, the skin layer (e) is in direct contact with sublayer (d1). The skin layer (e) includes (i) from 50 wt% to 0 wt%, or from 50 wt% to 10 wt%, or from 40 wt% to 20 wt%, or 30 wt% of the SL first ethylene/α-olefin copolymer. In an embodiment, the SL first ethylene/α-olefin copolymer has a density from 0.900 g/cc to 0.920 g/cc, a melt index from 0.5 g/10 min to 1.5 g/10 min, or from 0.5 g/10 min to less than 1.0 g/10 min, and a melt temperature from 95°C to 125°C, or from 105°C to 110°C. The skin layer (e) includes (ii) from 50% to 100 wt%, or from 50 wt% to 90 wt%, or from 60 wt% to 80 wt%, or 70 wt% of the SL second ethylene/α-olefin copolymer. In an embodiment, the SL second ethylene/α-olefin copolymer has a density from 0.935 g/cc to 0980 g/cc, or from 0.940 g/cc to 0.980 g/cc, or from 0.960 g/cc to 0.980 g/cc, a melt index from 0.5 g/10 min to 1.5 g/10 min, or from greater than 1.0 g/10 min to 1.5 g/10 min, and a melt temperature from 125°C to 135°C, or from 130°C to 135°C. The SL first ethylene/α-olefin is different than the SL second ethylene/α-olefin. Weight percent is based on total weight of the skin layer (e).

In an embodiment, the skin layer (e) is in direct contact with one of the sublayers other than (d1), namely (d2), or (d3), or (d4), or (d5). The skin layer (e) includes from 90 wt% to 100 wt% (and optional additive), or 100 wt% of the SL first ethylene/α-olefin copolymer having a density from 0.935 g/cc to 0.980 g/cc, or from 0.940 g/cc to 0.980 g/cc, or from 0.960 g/cc to 0.980 g/cc, a melt index from 0.5 g/10 min to 1.5 g/10 min, or from greater than 1.0 g/10 min to 1.5 g/10 min, and a melt temperature from 125°C to 135°C, or from 130°C to 135°C. Weight % is based on the total weight of the second skin layer (e).

### 2. Additives

Each layer in the MDO multilayer film may include one or more optional additives. Nonlimiting examples of suitable additive include antioxidants, such as IRGANOX 1010 and IRGAFOS 168 (commercially available from BASF), ultraviolet light absorbers, antistatic agents, pigments, dyes, nucleating agents, fillers, slip agents, fire retardants, plasticizers, polymer processing aids (PPA), lubricants, stabilizers, smoke inhibitors, viscosity control agents, surface modification agents, and anti-blocking agents. When present, the additive(s) amount(s) to greater than 0 wt% to 5 wt%, or from 0.01 wt% to 4 wt%, or from 0.01 wt% to 3 wt%, or from 0.01 wt% to 2.0 wt%, or from 0.01 wt% to 1.0 wt%, or from 0.05 wt% to 1.0 wt% of the MDO multilayer film layer. Weight % is based on total weight of the respective film layer containing the additive(s).

### 3. Metal layer

The MDO multilayer film includes a metal layer. The metal layer is on the first outer layer (a) and the metal layer directly contacts the first outer layer (a). In an embodiment, the first outer layer (a) is exposed to plasma treatment prior to metal/metal oxide deposition to improve metal adhesion.

Nonlimiting examples of plasma treatment techniques include solution spraying, spinning, coating, or the addition of hydrophilic additives onto the film structure. For example, a hydrophilic treatment can be applied via a plasma treatment where the film structure is exposed to an atmospheric plasma comprising an inert gas and a substance having a polar group and which can be vaporized or made into an aerosol and which forms a free radical upon exposure to a dielectric barrier discharge. Atmospheric plasma systems and methods are generally described in U.S. Pat. No. 5,433,786, the disclosure of which is incorporated herein by reference.

A metal (and/or a metal oxide) is deposited on the first outer layer (a) of the MDO multilayer film. Nonlimiting procedures for which the metal/metal oxide can be applied to the first outer layer (a) include vapor deposition (chemical or physical) or vacuum metallization. For vacuum metallization, a metal source is evaporated in a vacuum environment, and the metal vapor condenses on the surface of the film to form a thin layer as the film passes through the vacuum chamber. Nonlimiting examples of suitable metals for the metal layer include aluminum (Al), silicon (Si), zinc (Zn), gold (Au), silver (Ag), copper (Cu), nickel (Ni), chromium (Cr), germanium (Ge), selenium (Se), titanium (Ti), tin (Sn), oxides thereof, and combinations thereof. The metal layer has a thickness from 10 to 60 nanometers (nm) or from 15 nm to 60 nm, or from 10 nm to 45 nm, or from 15 nm to 45 nm, or from 15 nm to 40 nm. The bond strength (interchangeably referred to as metal adhesion) for the metal layer to the first outer layer (a) is greater than or equal to 1.5 N/25mm, or from 1.5 N/25mm to 12.0 N/25mm, or from 2.5 N/25mm to 10.0 N/25mm, or from 2.7 N/25mm to 9.0 N/25mm, or from 3.0 N/25mm to 8.5 N/25mm.

In an embodiment, the metal layer is formed from aluminum and/or oxides of aluminum (*e.g*., Al₂O₃) and the metal layer has a thickness from 10 nm to 60 nm, or from 15 nm to 60 nm, or from 10 nm to 45 nm, or from 15 nm to 45 nm, or from 15 nm to 40 nm.

In an embodiment, the film structure has a thickness from 20 microns to 30 microns, or 25 microns and includes
the first outer layer (a) which includes
   (i) from 60 wt% to 90 wt%, or from 70 wt% to 90 wt% of the FOL first ethylene/α-olefin copolymer having a density from 0.900 g/cc to 0.920 g/cc, a melt index from 0.5 g/10 min to 1.5 g/ 10 min, and a melt temperature from 95°C to 125°C, or from 105°C to 110°C, or from 110°C to 125°C, or a melt temperature from 120°C to 125°C, and
   (ii) from 40 wt% to 10 wt%, or from 30 wt% to 10 wt%, of another ethylene-based polymer selected from
      (1) the FOL second ethylene/α-olefin copolymer having a density from 0.935 g/cc to 0.980 g/cc, or from 0.960 g/cc to 0.980 g/cc, a melt index from 0.5 g/10 min to 1.5 g/ 10 min, and a melt temperature from 125°C to 135°C, or from 130°C to 135°C, or
      (2) the FOL third ethylene-based polymer that is a low density polyethylene;
      the first intermediate layer (b) which includes
      (i) the FIL first ethylene/α-olefin copolymer having a density from 0.935 g/cc to 0.980 g/cc and optionally
      (ii) the FIL second ethylene/α-olefin copolymer having a density from 0.935 g/cc to 0.980 g/cc, or from 0.960 g/cc to 0.980 g/cc, a melt index from 0.5 g/10 min to 1.5 g/10 min, or from greater than 1.0 g/10 min to 1.5g/10 min, and a melt temperature from 125°C to 135°C, or from 130°C to 135°C;
the core layer (c) which includes
   (i) the CL first ethylene/α-olefin copolymer from 0.935 g/cc to 0.980 g/cc, or from 0.940 g/cc to 0.950 g/cc, a melt index from 0.5 g/10 min to 1.5 g/10 min, or from 0.5 g/10 min to less than 1.0 g/10 min, and a melt temperature from 125°C to 135°C, or from 125°C to 129°C;
one or more optional sublayers (d1), (d2), (d3), d4), (d5);
the skin layer (e) which includes
   (i) the SL first ethylene/α-olefin copolymer having a density from 0.935 g/cc to 0.980 g/cc, or from 0.960 g/cc to 0.980 g/cc, a melt index from 0.5 g/10 min to 1.5 g/10 min, or from greater than 1.0 g/10 min to 1.5g/10 min, and a melt temperature from 125°C to 135°C, or from 130°C to 135°C;
the metal layer has a thickness 10 nm to 60 nm and comprises a metal selected from aluminum, aluminum oxide, and combinations thereof; and
the film structure has one, some, or all of the following properties
   (1) an OTR value from 0.1 cm³/m²day to 120 cm³/m²/day, or from 0.5 cm³/m²/day to 115 cm³/m²/day, or from 0.7 cm³/m²/day to 110 cm³/m²/day, and/or
   (2) a WVTR value from 0.1 g/m²/day to 2.5 g/m²/day, or from 0.2 g/m²/day to 2.0 g/m²/day, or from 0.3 g/m²/day to 1.9 g/m²/day, and/or
   (3) a metal adhesion value from 2.5 N/25mm to 10 N/25mm, or from 2.7 N/25mm to 9.0 N/25mm, or from 3.0 N/25mm to 8.5 N/25mm.

In an embodiment, the MDO multilayer film comprises at least 95 wt%, or at least 97 wt%, or at least 99 wt% ethylene-based polymers, based on the total weight of the MDO multilayer film.

In an embodiment, the MDO multilayer film consists of only ethylene-based polymer (with exception to the metal layer).

### TEST METHODS

Density is measured in accordance with ASTM D792, Method B. Results are reported in grams per cubic centimeter (g/cc).

Melt index (I₂) is measured in accordance with ASTM D-1238 at 190°C at 2.16 kg. The values are reported in g/10 min, which corresponds to grams eluted per 10 minutes.

Melt temperature. The differential scanning calorimetry (DSC) measurements were performed on a Differential Scanning Calorimeter. The samples (^{~}3 mg) were loaded into aluminum calorimetry pans, and heated from -40 °C to 150 °C at a heating rate of 10 °C/min under Nitrogen atmosphere. Samples were exposed to one full heating and cooling cycle to remove any thermal history before measurement.

Metal layer adhesion. The adhesion strength (or "bond strength" or "metal adhesion") of the metal layer to the first outer layer (layer (a)) of each MDO multilayer film is measured as follows. Each film structure is heat sealed to a 100 micron film made from ethylene acrylic acid copolymer having an acrylic acid content of ^{~}7% ("the EAA film"), with the metal layer of the film structure being in contact with the EAA film. The film structure and the EAA film are heat sealed by placing the films between an upper jaw at 110°C and a lower jaw at 70°C, with the upper jaw being in contact with the EAA film and the lower jaw in contact with the film structure. The jaws are in contact with the EAA film and the film structure for 20 seconds under pressure of 5 bars. After 24 hours aging at room temperature, the metal adhesion strength (or bonding strength) is then measured using an Instron 5567 tensile machine, by measuring T-Peel at a testing speed of 12 inches/minute with a load cell of 100 N. The average value is reported as the metal adhesion strength (or bonding strength) between the first outer layer (a) of the MDO multilayer film and the metal layer, with results reported as newtons (N) per 25 mm, or N/25mm.

Optical density test method. A densitometer instrument is used to measure the optical density of the film. Mark the sample with 10 evenly spaced intervals across the width with the metal side up. Place the densitometer in the diffuse mode and set for visual light tramsmittance. Test the sample with metal side up. Special care to be taken in handling the material to avoid scratches, pinholes, etc. USA Standard Number PH2-19-1959 provides the basic for the concept of diffuse optical density.

Oxygen Transmission Rate (OTR). Oxygen transmission rate (OTR) is measured in accordance with ASTM D3985. Samples are tested at 23°C, 0% relative humidity (RH), 50 cm² sample size. The values are reported in cm³/day/m².

Water Vapor Transmission Rate (WVTR). Water Vapor Transmission Rate (WVTR) is measured in accordance with ASTM F1249. Samples are tested at 37.8°C, 100% RH, and 50 cm² sample size. The values are reported in g/day/m².

By way of example, and not limitation, examples of the present disclosure are provided.

### EXAMPLES

The materials used in comparatives samples (CS) and inventive examples (IE) are provided in Table 1.

**Table 1 - Materials**

| Component | Details | Source |
|---|---|---|
| MDO film | | |
| XUS 69B1003.00 | Maleic anhydride functionalized ethylene copolymer, density 0.884 g/cc, MI 2.5 g/10 min, Tm 120°C | The Dow Chemical Company |
| ADSYL 3C30FHP | density 0.90g/cc, MFR (230°C, 2.16kg) 5.5 g/10 min, Tm 137°C | |
| AFFINITY^{™} PL 1880G | Ethylene-octene copolymer, density 0.902 g/cc, MI 1.0, Tm 99°C | The Dow Chemical Company |
| AFFINITY^{™} PL 1881G | Ethylene/octene copolymer, density 0.904 g/cc, MI 1.0, Tm 100°C | The Dow Chemical Company |
| BYNEL^{™} 22E780 | Modified ethylene acrylate, density 0.94 g/cc, MI 2.0 g/10 min, Tm 91°C | The Dow Chemical Company |
| BYNEL^{™} 41E687B | Maleic anhydride modified LLDPE. Density 0.91 g/cc, MI 1.7, Tm 119°C | The Dow Chemical Company |
| DOWLEX^{™} 2038.68 | LLDPE ethylene/octene copolymer, density 0.935 g/cc, MI1.0 g/10 min, Tm 126°C | The Dow Chemical Company |
| ELITE^{™} 5400GS | Ethylene-octene copolymer, density 0.916 g/cc, MI 1.0 g/10 min, Tm 123°C | The Dow Chemical Company |
| ELITE^{™} 5401GT | Ethylene-octene copolymer, density 0.918 g/cc, MI 1.0 g/10 min, Tm 123°C | The Dow Chemical Company |
| ELITE^{™} 5940ST | Ethylene-octene copolymer, density 0.941 g/cc, MI 0.8 g/10 min, Tm 126°C | The Dow Chemical Company |
| ELITE 5960G1 | Ethylene-octene copolymer, density 0.962 g/cc, MI 0.85 g/10 min, Tm 134°C | The Dow Chemical Company |
| ELITE^{™} AT 6410 | Ethylene copolymer, density 0.912 g/cc, MI 0.85 g/10 min, Tm 108°C | The Dow Chemical Company |
| ELITE^{™} AT 6900 | Ethylene/octene copolymer density 0.969 g/cc, MI 1.2 g/10 min, Tm 134°C, | The Dow Chemical Company |
| EVAL J171B | ethylene vinyl alcohol (EVOH) density 1,7 g/cc, MI 1.7, Tm 183°C | Kuraray |
| | | |
| INNATE^{™} TH 60 | Ethylene copolymer, density 0.912 g/cc, MI 0.85 g/10 min, Tm 123C | The Dow Chemical Company |
| LD 100BW | LDPE 2MI, density 0.923 g/cc, MI 2.0 g/10 min, Tm 110°C | Exxon Mobil |

### 1. Fabrication of MDO multilayer films

Five coextruded multilayer films--comparative sample (CS) 1, CS2, inventive example (IE) IE3, IE4, and IE5 --each had a primary film thickness of 125 microns. Each multilayer film was stretched 5.5 times to obtain a MDO multilayer film having a thickness of 25 microns using a HOSOKAWA ALPINE blown film line with MDO in-line stretching unit. The layer configuration/composition and layer volume percent for each multilayer film CS1, CS2, IE3, IE4, and IE5 is provided in respective Tables 2A-2E below.

**Table 2A CS1-MDO multilayer film -25 micron thickness**

| | CS1 |
|---|---|
| 1^{st} Outer layer (a) -10% | 90% 6900+10% 5400GS |
| 1^{st} intermediate (b)- 20% | 5940ST |
| Core layer (c)10% | 5400GS |
| Tie layer-10% | BYNEL^{™} 41E687B |
| barrier layer -10% | T101B |
| Tie Layer-10% | BYNEL^{™} 41E687B |
| 1^{st} sublayer (d1) -10% | 5400GS |
| 2^{nd} sublayer (d2) -10% | 5940ST |
| Skin layer (e) -10% | 6900 |

| | |
|---|---|
| Weight percent (where indicated) based on total weight for the respective layer | |

**Table 2B CS2 - MDO multilayer film - 25 micron thickness**

| | CS2 |
|---|---|
| 1^{st} Outer layer (a)-15% | 92% ADSYL 3C30FHP + 8% BYNEL 22E780 |
| 1^{st} intermediate (b)-12.5% | 5940ST - 75% + PL 1880G - 25% |
| Core layer (c)-12.5% | 5940ST - 75% + PL 1880G - 25% |
| 1^{st} Sublayer (d1)-7% | 5400GS |
| 2^{nd} Sublayer (d2)-6% | 5400GS |
| 3^{rd} Sublayer (d3)-7% | 5400GS |
| 4^{th} Sublayer (d4) -12.5% | 5940ST |
| 5^{th} Sublayer (d5)-12.5% | 5940ST |
| Skin layer (e)-15% | 6900 |

| | |
|---|---|
| Weight percent (where indicated) based on total weight for the respective layer | |

**Table 2C IE3-MDO multilayer film -25 micron thickness**

| | IE3 |
|---|---|
| 1^{st} outer layer (a) -14% | 85% INNATE TH 60+ 15% ELITE AT 6900 |
| 1^{st} intermediate layer (b) - 21% | 30% 6900+ 70% 5940ST |
| Core layer (c) - 30% | 5940ST |
| 1^{st} sublayer (d1) - 24.5% | 30%6900+ 70%5940ST |
| 2^{nd} outer layer (e) -10.5% | 30% TH 60+ 70% 6900 |

| | |
|---|---|
| Weight percent (where indicated) based on total weight for the respective layer | |

**Table 2D IE4-MDO multilayer film -25 micron thickness**

| | IE4 |
|---|---|
| 1^{st} outer layer (a)-14% | 85% ELITE AT 6410 + 15% ELITE AT 6900 |
| 1^{st} intermediate layer (b)- 21% | 30% 6900+70% 5940ST |
| Core layer (c)- 30% | 5940ST |
| 1^{st} sublayer (d1) - 24.5% | 30% 6900+70% 5940ST |
| Skin layer (e)-10.5% | 30% ELITE AT 6410+ 70% 6900 |

| | |
|---|---|
| Weight percent (where indicated) based on total weight for the respective layer | |

**Table 2E IE5-MDO multilayer film -25 micron thickness**

| | IE5 |
|---|---|
| 1^{st} outer layer (a)-11% | 80% ELITE AT 6410 + 20% LDPE 2MI |
| 1^{st} intermediate layer (b)-16% | 5940ST |
| Core layer (c) - 8% | 5940ST |
| 1^{st} sublayer (d1) - 9% | 69B1003.00 |
| 2nd sublayer (d2) - 8% | J171B |
| 3^{rd} sublayer(d3)-9% | 69B1003.00 |
| 4^{th} sublayer (d4)-12% | 5940ST |
| 5^{th} sublayer (d5)-11% | 6900 |
| Skin layer (e)-16% | 6900 |

| | |
|---|---|
| Weight percent (where indicated) based on total weight for the respective layer | |

### 2. Fabrication of film structures with metal layer

Each MDO multilayer film (CS1, CS2, IE3, IE4, IE5) is subjected to plasma treatment. Following plasma treatment, a metal layer of aluminum metal is applied to the first outer layer (a) of each MDO multilayer film CS1, IE2, IE3 and IE4.

In Table 3 below, each film structure has a MDO multilayer film and an aluminum metal layer with the following optical density values: CS1 3.3; CS2 3.4; IE3 2.4; IE4 2.8; and IE5 2.8. The aluminum metal layer is in direct contact with the first outer layer (a) for each MDO multilayer film.

**Table 3 -Film structure properties**

| Film structure | OTR | WVTR | Metal adhesion |
|---|---|---|---|
| CS1 | 0.98 | 2.9 | 2.1 |
| Layer(a)--90%6900+10%5400GS//5940ST//5400GS//BYNEL^{™} 41E687B//3µEVOPH// BYNEL^{™} 41E687B//5400GS//5940ST//6900 | | | |
| CS2 | 14.8 | 0.68 | 0.73 |
| Layer(a)--92% ADSYL 3C30FHP + 8% BYNEL^{™}22E780//75% 5940ST+ 25% PL1880G//75% 5940ST + 25% PL1880G // 5400GS//5400GS//5400GS//5940ST//5940ST//6900 | | | |
| IE3 | 106 | 1.78 | 8.3 |
| Layer(a)--85%TH60 + 15% 6900//30% 6900 + 70%5940ST//5940ST//30% 6900 + 70%5940ST// 30% TH60 + 70% 6900 | | | |
| IE4 | 25.1 | 0.40 | 7.7 |
| Layer(a)--85% 6410 + 15% 6900//30% 6900 + 70% 5940ST//5940ST//30% 6900 + 70% 5940ST// 30% 6410 + 70% 6900 | | | |
| IE5 | 0.89 | 0.7 | 3.2 |
| Layer(a)--80% 6410 + 20%LDPE//5940ST//5940ST//69B1003.00//EVOH//XUS 69B1003.00//5940ST//6900//6900 | | | |

| | | | |
|---|---|---|---|
| Weight percent (where indicated) based on total weight for the respective layer | | | |

Inventive examples IE3, IE4, IE5 each unexpectedly exhibits excellent OTR (from 0.1 cm³/m²day to 120 cm³/m²/day) and excellent WVTR (0.1 g/m²/day to 2.5 g/m²/day) while simultaneously providing strong metal adhesion (2.5 N/25mm to 10 N/25mm).

It is specifically intended that the present disclosure not be limited to the embodiments and illustrations contained herein, but include modified forms of those embodiments including portions of the embodiments and combinations of elements of different embodiments as come within the scope of the following claims.

## Claims

1. A film structure comprising:
a machine direction oriented (MDO) multilayer film comprising
(a) a first outer layer (FOL) comprising
(i) a FOL first ethylene/α-olefin copolymer having a density from 0.900 g/cc to 0.920 g/cc, and
(ii) an optional ethylene-based polymer selected from the group consisting of
(1) a FOL second ethylene/α-olefin copolymer having a density from 0.920 g/cc to 0.980 g/cc; and
(2) a FOL third ethylene-based polymer (LDPE);
(b) a first intermediate layer (FIL) in direct contact with the first outer layer, the first intermediate layer (FIL) comprising an FIL first ethylene/α-olefin copolymer having a density from 0.920 g/cc to 0.980 g/cc;
(c) a core layer (CL) in direct contact with the first intermediate layer, the core layer comprising a CL first ethylene-based polymer having a density from 0.920 g/cc to 0.980 g/cc; and
a metal layer on the first outer layer (a).

2. The film structure of claim 1 wherein the first outer layer (a) comprises
(i) from 50 wt% to 100 wt% of the FOL first ethylene/α-olefin copolymer having a density from 0.900 g/cc to 0.920 g/cc and a melt temperature from 95°C to 125°C, and
(ii) from 50 wt% to 0 wt%, of the FOL second ethylene/α-olefin copolymer having a density from 0.940 g/cc to 0.980 g/cc and a melt temperature from 125°C to 135°C, weight % is based on the total weight of first outer layer (a).

3. The film structure of claim 1 wherein the first outer layer (a) comprises
(i) from 50 wt% to 100 wt% of the FOL first ethylene/α-olefin copolymer having a density from 0.900 g/cc to 0.920 g/cc and a melt temperature from 95°C to 125°C, and
(ii) from 50 wt% to 0 wt% of the FOL third ethylene-based polymer that is a low density polyethylene.

4. The film structure of any of claims 1-3 wherein the first intermediate layer (b) comprises from 90 wt% to 100 wt% of the FIL first ethylene/α-olefin copolymer having a density from 0.935 g/cc to 0.980 g/cc and a melt temperature from 125°C to 135°C, weight % is based on total weight of the intermediate layer (b).

5. The film structure of any of claims 1-3 wherein the first intermediate layer comprises
(i) from 60 wt% to 90 wt% of the FIL first ethylene/α-olefin copolymer having a density from 0.935 g/cc to 0.980 g/cc and a melt temperature from 125°C to 135°C; and
(ii) from 40 wt% to 10 wt% of a FIL second ethylene/α-olefin copolymer having a density from 0.940 g/cc to 0.980 g/cc and a melt temperature from 125°C to 135°C, and weight % is based on total weight of the first intermediate layer (b).

6. The film structure of any of claims 1-5 wherein the core layer (c) comprises from 90 wt% to 100 wt% of the CL first ethylene/α-olefin copolymer having a density greater than or equal to 0.935 g/cc to 0.980 g/cc and a melt temperature from 125°C to 135°C, weight % is based on total weight of the core layer (c).

7. The film structure of claim 6 comprising a first sublayer (d1) in direct contact with the core layer (c), the first sublayer (d1) comprising an ethylene-based polymer.

8. The film structure of any of claims 1-7 comprising a skin layer (e) comprising a SK first ethylene/α-olefin copolymer having a density from 0.935 g/cc to 0.980 g/cc.

9. The film structure of any of claims 1-8 wherein the metal layer is in direct contact with the first outer layer (a) and the metal layer comprises a metal selected from the group consisting of Al, Si, Zn, Au, Ag, Cu, Ni, Cr, Ge, Se, Ti, Sn, oxides thereof, and combinations thereof.

10. The film structure of claim 9 wherein the metal layer comprises a component selected from the group consisting of Al metal, Al oxide, and combinations thereof.

11. The film structure of any of claims 1-10 wherein the metal layer has thickness from 10 nanometers to 60 nanometers.

12. The film structure of any of claims 1-11 wherein the film structure comprises
the first outer layer (a) comprising
(i) from 70 wt% to 90 wt% of the FOL first ethylene/α-olefin copolymer having a density from 0.900 g/cc to 0.920 g/cc, and
(ii) from 30 wt% to 10 wt%, of another ethylene-based polymer selected from the group consisting of
(1) the FOL second ethylene/α-olefin copolymer having a density from 0.935 g/cc to 0.980 g/cc and a melt temperature from 125°C to 135°C, and
(2) the FOL third ethylene-based polymer that is a low density polyethylene;
the first intermediate layer (b) comprising
(i) the FIL first ethylene/α-olefin copolymer having a density from 0.935 g/cc to 0.980 g/cc;
the core layer (c) comprising
(i) the CL first ethylene/α-olefin copolymer having a density from 0.935 g/cc to 0.980 g/cc;
one or more optional sublayers;
a skin layer (SL) comprising
(i) a SL first ethylene/α-olefin copolymer having a density from 0.935 g/cc to 0.980 g/cc;
the metal layer comprising a metal selected from the group consisting of aluminum, aluminum oxide, and combinations thereof; and
the film structure has
(1) an OTR value from 0.1 cm³/m²day to 120 cm³/m²/day,
(2) a WVTR value from 0.1 g/m²/day to 2.5 g/m²/day, and
(3) a metal adhesion value from 2.5 N/25mm to 10 N/25mm.
